# EUROPEAN PATENT APPLICATION

(11) **EP 4 672 870 A1**
(43) Date of publication of application: **31.12.2025**
(21) Application number: 24779522.2
(22) Date of filing: 14.03.2024
(51) Int. Cl.: H05K 1/02, G09F 9/00, H01L 23/12

(54) **CONDUCTIVE FILM AND DISPLAY DEVICE**

(30) Priority: 28.03.2023 JP 2023051516
(71) Applicant: TDK Corporation, Tokyo 103-6128 (JP)
(72) Inventor: NISHIOKA Keisuke, Tokyo 103-6128 (JP); SHINGAI Hiroshi, Tokyo 103-6128 (JP)
(74) Representative: Epping - Hermann - Fischer
(86) International application number: PCT/JP2024/010020
(87) International publication number: WO 2024/203393

(57) **Abstract**

A conductive film includes a film-shaped base material and a structure provided on one or each of two main surfaces of the base material. The structure includes a first resin layer provided at a position farthest from the main surface of the base material, an intermediate layer provided between the first resin layer and the base material, a pattern including a linear trench formed along the main surface of the base material, and a conductive part filled in the pattern. A bottom portion of the trench is positioned closer to the base material than an interface between the first resin layer and the intermediate layer.

## Description

### Technical Field

The present disclosure relates to a conductive film and a display device.

### Background Art

A conductive film including a transparent antenna having transparency and conductivity may be mounted on a surface of a touch panel or a display.

For example, Patent Literature 1 described below discloses a conductive film formed by providing a base layer and a trench-forming layer in this order on a base material, forming a mesh-like trench pattern having linear trenches in the trench-forming layer, and forming a mesh-like conductive pattern by filling the trench pattern with a conductive part.

### Citation List

### Patent Literature

Patent Literature 1: Japanese Unexamined Patent Publication No. 2019-029658

### Summary of Invention

### Technical Problem

However, the conductive film described in Patent Literature 1 has the following problems.

That is, in the conductive film described in Patent Literature 1 described above, in a case where the width of the conductive part with which a linear trench is filled is narrowed, the transparency of the conductive film is improved, but the volume of the conductive part is reduced. For this reason, the resistance of the conductive part increases and the electrical conductivity decreases. Thus, there is room for improvement in terms of both high transparency and high conductivity.

In addition, the conductive film described in Patent Literature 1 described above has room for improvement also in terms of durability when placed in environments with large temperature changes.

An object of the present disclosure is to provide a conductive film capable of achieving both high transparency and high conductivity and improving durability.

### Solution to Problem

One aspect of the present disclosure provides a conductive film including: a film-shaped base material; and a structure provided on one or each of two main surfaces of the base material, in which the structure includes a first resin layer provided at a position farthest from the main surface of the base material, an intermediate layer provided between the first resin layer and the base material, a pattern including a linear trench formed along the main surface of the base material, a conductive part filled in the pattern, and a bottom portion of the trench is positioned closer to the base material than an interface between the first resin layer and the intermediate layer.

According to this conductive film, in the structure provided on one or each of the two main surfaces of the base material, the bottom portion of the trench to be filled with the conductive part is positioned closer to the base material than the interface between the first resin layer and the intermediate layer. Therefore, even though the width of the linear trench is narrowed, it is possible to minimize a decrease in the volume of the conductive part as compared to a case where the bottom portion of the trench is positioned at the interface between the first resin layer and the intermediate layer. Thus, it is possible to minimize an increase in the resistance of the conductive part filled in the linear trench and to improve the conductivity. In addition, since the width of the trench is narrowed, the transmittance of light incident from the surface of the structure opposite to the base material can be increased. Therefore, the conductive film can achieve both high transparency and high conductivity.

According to the above-described conductive film, in the structure provided on one or each of the two main surfaces of the base material, the bottom portion of the trench to be filled with the conductive part is positioned closer to the base material than the interface between the first resin layer and the intermediate layer. That is, the conductive part penetrates the first resin layer and further intrudes into at least the intermediate layer. Therefore, even in a case where a thermal expansion coefficient of the first resin layer and a thermal expansion coefficient of the intermediate layer are different from each other, the conductive film is placed in environments with large temperature changes, and the first resin layer and the intermediate layer expand or contract, the movement along the interface between the first resin layer and the intermediate layer is suppressed by the conductive part, the shear stress between the first resin layer and the intermediate layer is reduced, and delamination between the first resin layer and the intermediate layer is suppressed. Therefore, according to the above-described conductive film, durability can be improved.

Another aspect of the present disclosure provides a display device including the above-described conductive film.

In the above-described conductive film, the intermediate layer includes a second resin layer, and a Young's modulus of the second resin layer is preferably less than a Young's modulus of the first resin layer.

In this case, even though excessive stress is applied to the first resin layer, the stress is relieved by the second resin layer, so that generation of cracks in the base material and the first resin layer is suppressed.

In the above-described conductive film, the intermediate layer further includes a base layer between the second resin layer and the first resin layer, and a Young's modulus of the base layer is preferably less than the Young's modulus of the first resin layer.

In this case, even though excessive stress is applied to the first resin layer, the stress is relieved by the base layer. Thus, delamination at the interface between the second resin layer and the first resin layer (that is, delamination between the second resin layer and the first resin layer) is suppressed.

In the above-described conductive film, the intermediate layer further includes a base layer between the second resin layer and the first resin layer, and a Young's modulus of the base layer is preferably greater than the Young's modulus of the second resin layer.

In this case, even though excessive stress is applied to the first resin layer, the stress is gradually relieved by the base layer and the second resin layer. Thus, delamination at the interface between the second resin layer and the first resin layer is further minimized.

In the above-described conductive film, a bottom portion of the trench is positioned between the base layer and the base material.

In this case, the conductive part penetrates the first resin layer and the base layer of the intermediate layer, and further intrudes into at least the second resin layer. Therefore, even in a case where a thermal expansion coefficient of the first resin layer, a thermal expansion coefficient of the base layer of the intermediate layer, and a thermal expansion coefficient of the second resin layer of the intermediate layer are different from one another, the conductive film is placed in environments with large temperature changes, and the first resin layer, the base layer, and the second resin layer expand or contract, the movements along the interfaces between the first resin layer, the base layer, and the second resin layer are minimized by the conductive part, and delamination between the first resin layer and the base layer, and delamination between the base layer and the second resin layer are minimized. Therefore, the durability of the conductive film can be improved.

In the above-described conductive film, the pattern may include a plurality of the linear trenches intersecting each other.

In the above-described conductive film, the pattern may be a mesh-like pattern.

In the present disclosure, the Young's modulus refers to a Young's modulus measured using a nanoindentation method.

### Advantageous Effects of Invention

According to the present disclosure, a conductive film and a display device, capable of achieving both high transparency and high conductivity and improving durability, are provided.

### Brief Description of Drawings

FIG. 1 is a plan view illustrating a conductive film according to an embodiment of the present disclosure.
FIG. 2 is a cross-sectional view taken along line II-II in FIG. 1.
FIG. 3 is an enlarged plan view of the vicinity of an intersecting portion where two linear trenches and two linear portions of conductive parts intersect each other.
FIG. 4 is a partially enlarged view of FIG. 2.
FIG. 5 is a cross-sectional view illustrating an embodiment of a display device of the present disclosure.
FIG. 6 is a partial cross-sectional view illustrating another example of the conductive film of the present disclosure.
FIG. 7 is a partial cross-sectional view illustrating another example of the conductive film of the present disclosure.
FIG. 8 is a partial cross-sectional view illustrating another example of the conductive film of the present disclosure.
FIG. 9 is a partial cross-sectional view illustrating another example of the conductive film of the present disclosure.
FIG. 10 is a partial cross-sectional view illustrating another example of the conductive film of the present disclosure.

### Description of Embodiments

Embodiments of the present disclosure will be described in detail below.

### <Conductive Film>

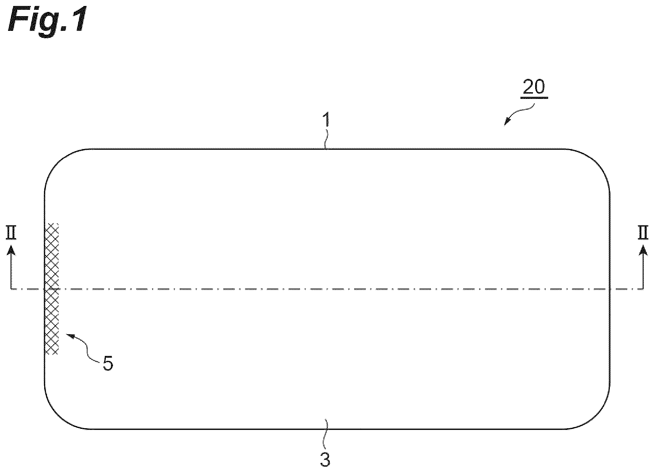

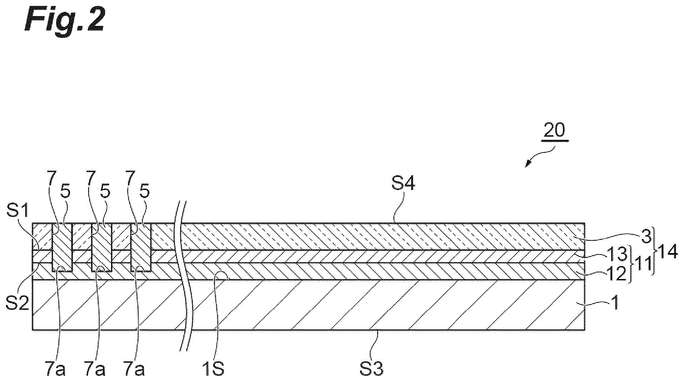

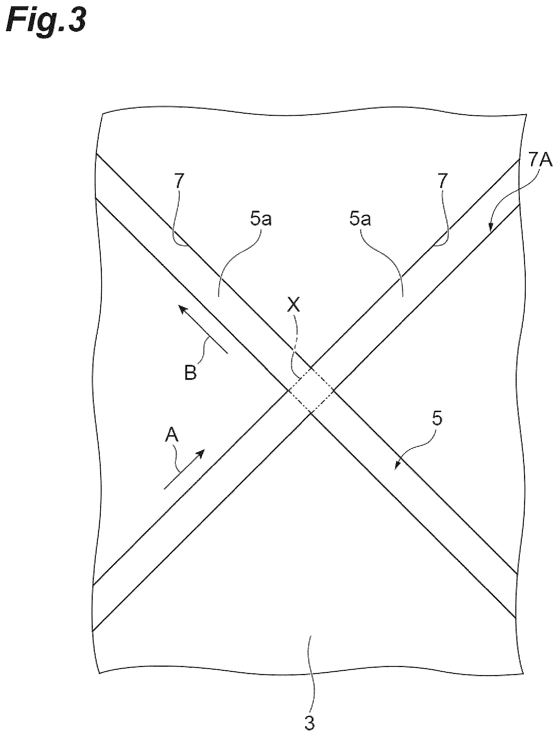

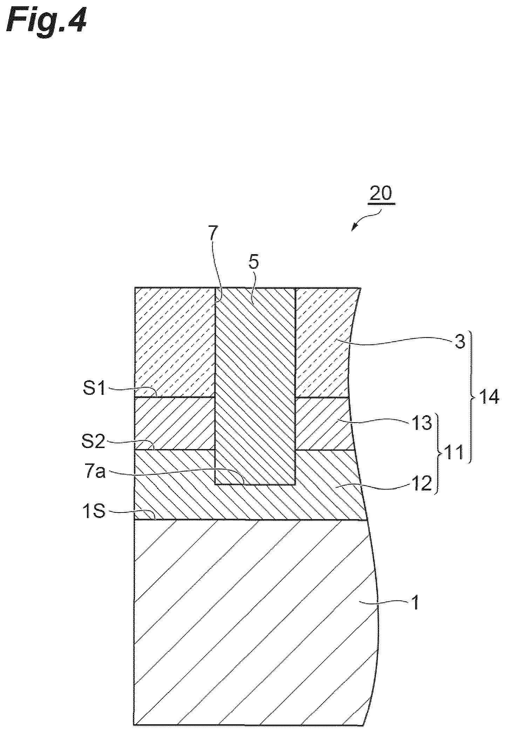

First, an embodiment of a conductive film of the present disclosure will be described with reference to the drawings. FIG. 1 is a plan view illustrating a conductive film according to an embodiment of the present disclosure. FIG. 2 is a cross-sectional view taken along line II-II in FIG. 1. FIG. 3 is an enlarged plan view of the vicinity of an intersecting portion where two linear trenches and two linear portions of conductive parts intersect each other. FIG. 4 is a partially enlarged view of FIG. 2.

A conductive film 20 illustrated in FIGS. 1 and 2 mainly includes a film-shaped base material 1, and a structure 14 provided on one main surface 1S side of the base material 1. The structure 14 includes a first resin layer 3 provided at a position farthest from the main surface 1S of the base material 1, an intermediate layer 11 provided between the first resin layer 3 and the base material 1, a pattern 7A including a linear trench 7 formed along the main surface 1S of the base material 1, and a conductive part 5 filled in the pattern 7A. The intermediate layer 11 includes a second resin layer 12 and a base layer 13 in this order from the base material 1 side. As illustrated in FIG. 4, a bottom portion 7a of a trench 7 is positioned closer to the base material 1 than an interface (hereinafter, also referred to as a "first interface") S1 between the first resin layer 3 and the intermediate layer 11, and positioned between an interface (hereinafter, also referred to as a "second interface") S2 between the base layer 13 and the second resin layer 12 and the main surface 1S of the base material 1. The conductive film 20 may further include a protective layer (not illustrated) on a main surface S3 of the base material 1 opposite to the first resin layer 3 and the intermediate layer 11.

In the conductive film 20, as illustrated in FIG. 3, a plurality of linear trenches 7 extending along each of two directions A and B intersect each other at an intersecting portion X to form a mesh-like pattern 7A.

The conductive part 5 has a portion (linear portion) 5a provided in the linear trench 7. The conductive part 5 in the trench 7 also forms the mesh-like pattern 7A. The conductive part 5 having the mesh-like pattern 7A can function well as, for example, a radiating element of an antenna.

According to this conductive film 20, in the structure 14 provided on one main surface 1S of the base material 1, the bottom portion 7a of the trench 7 to be filled with the conductive part 5 is positioned closer to the base material 1 than the interface S1 between the first resin layer 3 and the intermediate layer 11, and positioned between the second interface S2 and the main surface 1S of the base material 1. Therefore, even though the width of the trench 7 is reduced, it is possible to minimize a decrease in the volume of the conductive part 5 as compared to a case where the bottom portion 7a of the trench 7 is positioned at the first interface S1 between the first resin layer 3 and the intermediate layer 11. Thus, it is possible to minimize an increase in the resistance of the conductive part 5 filled in the linear trench 7 and to improve the conductivity. In addition, since the width of the trench 7 is reduced, the transmittance of light incident from the surface S4 of the structure 14 opposite to the base material 1 can be increased. Therefore, the above-described conductive film 20 can achieve both high transparency and high conductivity.

According to the above-described conductive film 20, in the structure 14 provided on one main surface 1S of the base material 1, the bottom portion 7a of the trench 7 to be filled with the conductive part 5 is positioned closer to the base material 1 than the interface S1 between the first resin layer 3 and the intermediate layer 11, and positioned between the second interface S2 and the main surface 1S of the base material 1. That is, the conductive part 5 penetrates the first resin layer 3 and the base layer 13 and further intrudes into the second resin layer 12. Therefore, even in a case where the thermal expansion coefficients of the first resin layer 3, a thermal expansion coefficient of the base layer 13, and a thermal expansion coefficient of the second resin layer 12 are different from one another, the conductive film 20 is placed in environments with large temperature changes, and the first resin layer 3, the base layer 13, and the second resin layer 12 expand or contract, the movements along the interfaces S1 and S2 between the first resin layer 3, the base layer 13, and the second resin layer 12 are minimized by the conductive part 5, and delamination between the first resin layer 3 and the base layer 13, delamination between the base layer 13 and the second resin layer 12, and delamination between the second resin layer 12 and the base material 1 are minimized. Therefore, according to the above-described conductive film 20, durability can be improved.

Hereinafter, the base material 1, the first resin layer 3, the second resin layer 12, the base layer 13, the pattern 7A, the conductive part 5, and the protective layer will be described in detail.

### (Base Material)

The base material 1 may be a light transmissive base material. The light transmissive base material has, for example, light transmittance to an extent required when the conductive film 20 is incorporated in a display device. Specifically, the total light transmittance of the light transmissive base material may be 90% to 100%. The light transmissive base material may have a haze of 0% to 5%.

The light transmissive base material used as the base material 1 may be, for example, a transparent resin film, and examples thereof include a film of polyethylene terephthalate (PET), polycarbonate (PC), polyethylene naphthalate (PEN), cycloolefin polymer (COP), or polyimide (PI). Alternatively, the light transmissive base material may be a glass substrate.

The thickness of the base material 1 may be 1 µm or more, 10 µm or more, or 20 µm or more, and may be 500 µm or less, 200 µm or less, or 100 µm or less.

### (First Resin Layer)

The first resin layer 3 may be a layer formed of a resin having light transmissivity. The total light transmittance of the first resin layer 3 may be 90% to 100%. The first resin layer 3 may have a haze of 0% to 5%.

The resin for forming the first resin layer 3 may be a cured product of a curable resin composition (photocurable resin composition or thermosetting resin composition). The curable resin composition for forming the first resin layer 3 includes a curable resin, and examples thereof include an acrylic resin, an amino resin, a cyanate resin, an isocyanate resin, a polyimide resin, an epoxy resin, an oxetane resin, a polyester resin, an allyl resin, a phenolic resin, a benzoxazine resin, a xylene resin, a ketone resin, a furan resin, a COPNA resin, a silicon resin, a dicyclopentadiene resin, a benzocyclobutene resin, an episulfide resin, an ene-thiol resin, a polyazomethine resin, a polyvinyl benzyl ether compound, acenaphthylene, and an ultraviolet curable resin containing a functional group that causes a polymerization reaction with ultraviolet rays such as an unsaturated double bond, a cyclic ether, and a vinyl ether.

The thickness of the first resin layer 3 may be, for example, 500 nm or more, 1000 nm or more, or 2000 nm or more, and may be 20 µm or less, 10 µm or less, or 5 µm or less.

The Young's modulus of the first resin layer 3 is not particularly limited, and may be, for example, 2000 to 7000 MPa.

### (Second Resin Layer)

The second resin layer 12 is provided between the base material 1 and the base layer 13. Therefore, adhesion between the base material 1 and the base layer 13 can be improved.

The second resin layer 12 is a layer containing a resin. The second resin layer 12 may be a layer containing a resin and an inorganic filler. Examples of the resin constituting the second resin layer 12 include acrylic resin. Examples of the inorganic filler include silica.

The thickness of the second resin layer 12 may be, for example, 5 nm or more, 100 nm or more, or 200 nm or more, and may be 10 µm or less, 5 µm or less, or 2 µm or less.

The Young's modulus of the second resin layer 12 is not particularly limited, and may be less than the Young's modulus of the first resin layer 3 or may be equal to or more than the Young's modulus of the first resin layer 3, and is preferably less than the Young's modulus of the first resin layer 3.

In this case, even though excessive stress is applied to the first resin layer 3, the stress is relieved by the second resin layer 12. Therefore, generation of cracks in the base material 1 and the first resin layer 3 is suppressed, and delamination at the interface between the base material 1 and the first resin layer 3 is also suppressed.

A ratio R1 of the Young's modulus of the second resin layer 12 to the Young's modulus of the first resin layer 3 is not particularly limited as long as it is less than 1, and R1 is preferably 0.9 or less, and more preferably 0.8 or less. However, the ratio R1 is preferably 0.3 or more, and more preferably 0.5 or more.

### (Base layer)

The base layer 13 is a layer provided in order to form the conductive part 5 by electroless plating or the like. The base layer 13 may be a layer containing a catalyst and a resin. The base layer 13 may be a single layer or a laminate of a plurality of layers. The resin may be a cured product of a curable resin composition. Examples of a curable resin contained in the curable resin composition include an amino resin, a cyanate resin, an isocyanate resin, a polyimide resin, an epoxy resin, an oxetane resin, a polyester resin, an allyl resin, a phenolic resin, a benzoxazine resin, a xylene resin, a ketone resin, a furan resin, a COPNA resin, a silicon resin, a dicyclopentadiene resin, a benzocyclobutene resin, an episulfide resin, an ene-thiol resin, a polyazomethine resin, a polyvinyl benzyl ether compound, acenaphthylene, and an ultraviolet curable resin containing a functional group that causes a polymerization reaction with ultraviolet rays such as an unsaturated double bond, a cyclic ether, and a vinyl ether.

The catalyst contained in the base layer 13 may be an electroless plating catalyst. The electroless plating catalyst may be a metal selected from Pd, Cu, Ni, Al, Co, Au, Ag, Pd, Rh, Pt, In, and Sn, a metal selected from Pd, Cu, Ni, and Al, a metal selected from Pd, Cu, and Ni, or Pd. The catalyst may be used singly or in combination of two or more kinds thereof. Usually, the catalyst is dispersed in the resin as catalyst particles.

The content of the catalyst in the base layer 13 may be 3 mass% or more, 4 mass% or more, or 5 mass% or more, and may be 100 mass% or less, 50 mass% or less, or 25 mass% or less with respect to the total amount of the base layer 13.

The thickness of the base layer 13 may be, for example, 5 nm or more, 10 nm or more, or 30 nm or more, and may be 500 nm or less, 300 nm or less, or 150 nm or less.

The Young's modulus of the base layer 13 is not particularly limited, and may be smaller than the Young's modulus of the first resin layer 3 or may be equal to or more than the Young's modulus of the first resin layer 3, and is preferably smaller than the Young's modulus of the first resin layer 3.

In this case, even though excessive stress is applied to the first resin layer 3, the stress is relieved by the base layer 13. Thus, generation of cracks in the second resin layer 12 and the first resin layer 3 is suppressed, delamination at the interface between the second resin layer 12 and the first resin layer 3 (that is, delamination between the second resin layer 12 and the first resin layer 3) is suppressed.

A ratio R2 of the Young's modulus of the base layer 13 to the Young's modulus of the first resin layer 3 is not particularly limited as long as it is less than 1, and R2 is preferably 0.95 or less, and more preferably 0.85 or less. However, the ratio R2 is preferably 0.4 or more, and more preferably 0.6 or more.

The Young's modulus of the base layer 13 may be equal to or less than the Young's modulus of the second resin layer 12 or may be more than the Young's modulus of the second resin layer 12, and is preferably more than the Young's modulus of the second resin layer 12.

In this case, even though excessive stress is applied to the first resin layer 3, the stress is alleviated stepwise by the base layer 13 and the second resin layer 12. Thus, delamination at the interface between the second resin layer 12 and the first resin layer 3 is further minimized.

### (Pattern)

The angle between two linear trenches 7 intersecting each other does not need to be 90 degrees, and can be, for example, in a range of 40 degrees or more and 140 degrees or less.

### (Conductive Part)

The trenches 7 and the conductive part 5 are provided over a partial region of the main surface 1S of the base material 1.

The conductive part 5 may contain metal as a conductive material. The conductive part 5 may contain at least one metal selected from copper, nickel, cobalt, palladium, silver, gold, platinum, and tin, or may contain copper. The conductive part 5 may be a metal plating formed by a plating method. The conductive part 5 may further contain a non-metal element such as phosphorus as long as appropriate conductivity is maintained.

The aspect ratio of the conductive part 5 may be 0.1 or more, 0.5 or more, or 1.0 or more. By setting the aspect ratio of the conductive part 5 within the above-described range, the conductivity of the conductive part 5 can be further enhanced. The aspect ratio of the conductive part 5 may be 10.0 or less, 7.0 or less, or 4.0 or less. By setting the aspect ratio of the conductive part 5 within the above-described range, the difference in transmittance due to the angle with respect to the surface of the first resin layer 3 opposite to the base material 1 can be reduced. The aspect ratio of the conductive part 5 refers to a ratio of the thickness of the conductive part 5 to the width of the conductive part 5 (thickness/width).

The conductive part 5 may be a stacked body including a plurality of layers. For example, the conductive part 5 may include a first metal layer and a second metal layer which are sequentially formed from the main surface 1S side of the base material 1. The first metal layer may contain nickel. The second metal layer may contain copper. The thickness of the first metal layer may be, for example, 5 nm or more, 10 nm or more, or 50 nm or more, and may be 500 nm or less, 200 nm or less, or 100 nm or less.

The conductive film 20 may further include a blackened layer. The blackened layer may be provided between the eyes of a viewer viewing the conductive film 20 and the conductive part 5. For example, in a case where the eyes of the viewer are positioned on the main surface 1S side of the base material 1, the blackened layer may be provided on the side opposite to the base material 1 of the conductive part 5. In a case where the eyes of the viewer are positioned on the main surface S3 side opposite to the main surface 1S of the base material 1, the blackened layer may be provided on the base material 1 side of the conductive part 5. In this case, for example, the entire intermediate layer 11 may be a blackened layer, and a part of the intermediate layer 11 (the second resin layer 12 or the base layer 13) may be a blackened layer. The blackened layer can contribute to improvement in visibility of a display device in which the conductive film is incorporated. The blackened layer may be a layer similar to the first metal layer, and may be, for example, a layer containing copper and nickel. In this case, the content of nickel in the blackened layer may be 15 mass% or more and 60 mass% or less with respect to the total amount of copper and nickel. The thickness of the blackened layer may be, for example, 300 nm or more and 400 nm or less. The blackened layer may be a layer formed by treating the conductive part 5 with a treatment liquid containing Pd.

### (Protective Layer)

The conductive film 20 may further include a protective layer. The protective layer may be provided to cover the conductive part 5, or may be provided to cover the main surface S3 opposite to the main surface 1S of the base material 1. By providing the protective layer to cover the conductive part 5, scratching occurring on the conductive part 5 is minimized, and by providing the protective layer on the main surface S3 of the base material 1 opposite to the main surface 1S, scratching occurring on the base material 1 is minimized. The protective layer can be a layer similar to the second resin layer 12. The thickness of the protective layer may be, for example, 5 nm or more, 50 nm or more, or 500 nm or more, and may be 10 µm or less, 5 µm or less, or 2 µm or less.

### <Method for Producing Conductive Film>

The conductive film 20 can be produced, for example, by a method including pattern formation by an imprint method. An example of a method for producing the conductive film 20 includes steps of: preparing a laminate including a base material 1, a second resin layer 12, and a base layer 13, which are provided on one main surface 1S of the base material 1, in this order; forming a structure 14 on the main surface 1S of the base material 1 by providing a first resin layer 3 on the base layer 13 of the laminate; pressing a mold having linear protrusions onto the structure 14, followed by pulling out the mold from the structure 14 to form a pattern 7A including linear trenches 7 in the structure 14; and forming a conductive part 5 including linear portions 5a provided in the linear trenches 7 by a plating method including growing a metal plating from the base layer 13 exposed in the trenches 7. In a case where the first resin layer 3 is a layer containing a curable resin composition, the first resin layer 3 may be cured in a state where a mold is pressed into the first resin layer 3. In a case where the first resin layer 3 contains a photocurable resin composition, the first resin layer 3 may be irradiated with ultraviolet rays in a state where the mold is pressed into the first resin layer 3, thereby curing the first resin layer 3.

The pressure applied to the structure 14 by the protrusions of the mold used for the imprint method may be 2.0 MPa or less or 1.5 MPa or less.

In a case where a part of the second resin layer 12 remains at the bottom portion 7a of the trench 7 after the formation of the trench 7 by the imprint method, this may be removed before the formation of the conductive part 5. However, in a case where the trenches 7 are formed by the imprint method, the conductive part 5 having good conductivity can be efficiently formed by the plating method without requiring removal of the remaining resin layer.

The formation of the conductive part 5 by the plating method may include, for example, a step of forming a seed layer on the base layer 13 by an electroless plating method and a step of forming Cu plating on the seed layer by the electroless plating method. In this case, the seed layer may be the first metal layer, and the Cu plating may be the second metal layer.

### <Display Device>

Next, a display device of the present disclosure will be described.

The display device of the present disclosure can include the conductive film 20 as, for example, a planar transparent antenna. The display device may be, for example, a liquid crystal display device or an organic EL display device.

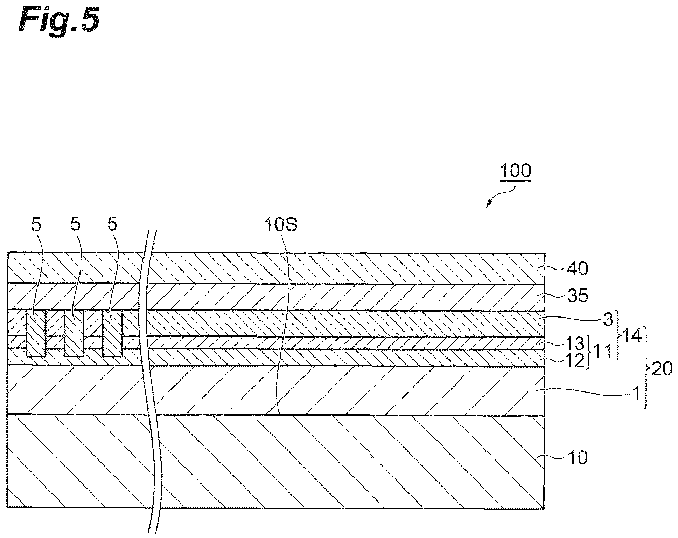

An embodiment of the display device of the present disclosure will be described with reference to FIG. 5. FIG. 5 is a cross-sectional view illustrating an example of a display device in which a conductive film is incorporated. A display device 100 illustrated in FIG. 5 includes an image display unit 10 having an image display region 10S, a conductive film 20, a polarizing plate 35, and a cover glass 40. The conductive film 20, the polarizing plate 35, and the cover glass 40 are laminated, in this order from the image display unit 10 side, on the image display region 10S side of the image display unit 10. The configuration of the display device is not limited to the form of FIG. 5, and can be appropriately changed as necessary. For example, the polarizing plate 35 may be provided between the image display unit 10 and the conductive film 20. The image display unit 10 may be, for example, a liquid crystal display unit. As the polarizing plate 35 and the cover glass 40, ones commonly used in a display device can be used. The polarizing plate 35 and the cover glass 40 need not necessarily be provided.

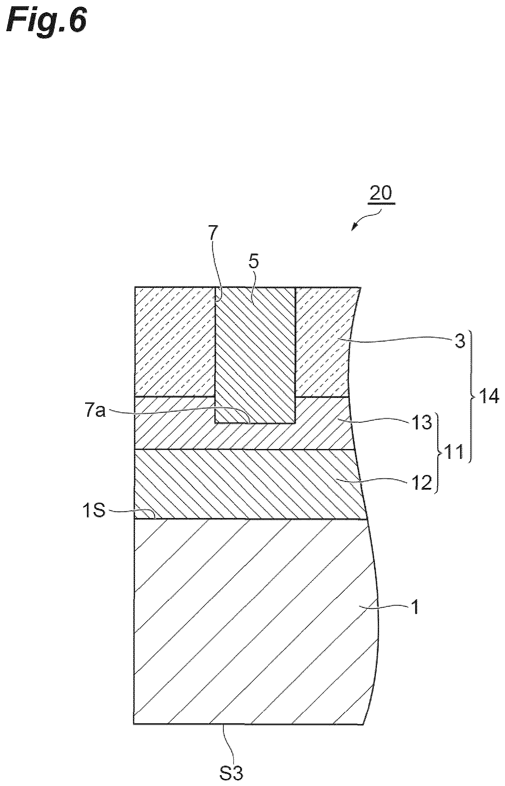

The present disclosure is not limited to the above-described embodiments. For example, in the above-described embodiment, although in the structure 14, the bottom portion 7a of the trench 7 to be filled with the conductive part 5 is positioned closer to the base material 1 side than the interface S1 between the first resin layer 3 and the intermediate layer 11 and positioned between the second interface S2 and the main surface 1S of the base material 1, the bottom portion 7a of the trench 7 may be positioned closer to the base material 1 side than the interface S1 between the first resin layer 3 and the base layer 13, or may be positioned between the interface S1 between the first resin layer 3 and the base layer 13 and the interface S2 between the base layer 13 and the second resin layer 12 as illustrated in FIG. 6. In addition, the bottom portion 7a of the trench 7 may penetrate the base layer 13 and the second resin layer 12 (that is, the intermediate layer 11) to be positioned in the base material 1 (that is, between the interface 1S between the intermediate layer 11 and the base material 1, and the surface (main surface) S3 of the base material 1 on the side opposite to the first resin layer 3).

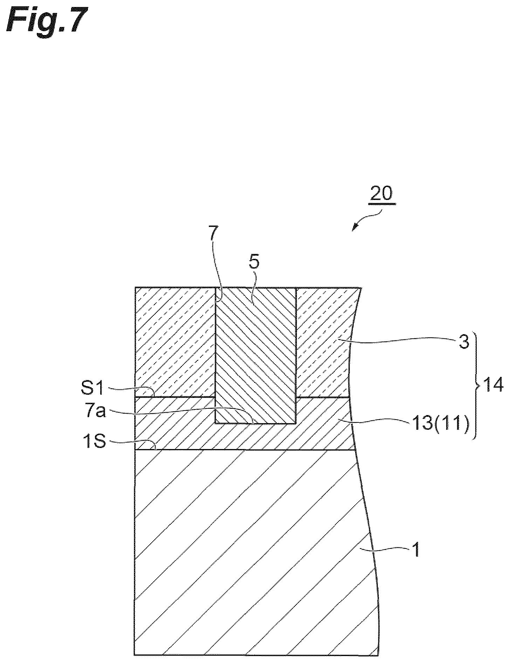

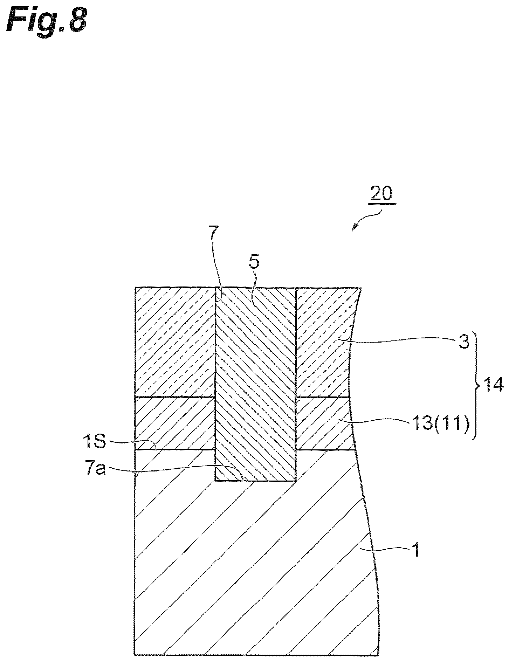

In the above-described embodiment, although the intermediate layer 11 includes the second resin layer 12 and the base layer 13, the second resin layer 12 is not necessarily provided. In this case, the intermediate layer 11 may be constituted by the base layer 13. The bottom portion 7a of the trench 7 is only sufficient to be positioned closer to the base material 1 than the interface S1 between the first resin layer 3 and the base layer 13, and for example, may coincide with the interface between the base layer 13 and the base material 1, may be positioned between the interface S1 between the first resin layer 3 and the base layer 13, and the interface 1S between the base layer 13 and the base material 1 as illustrated in FIG. 7, or may be positioned in the base material 1 as illustrated in FIG. 8.

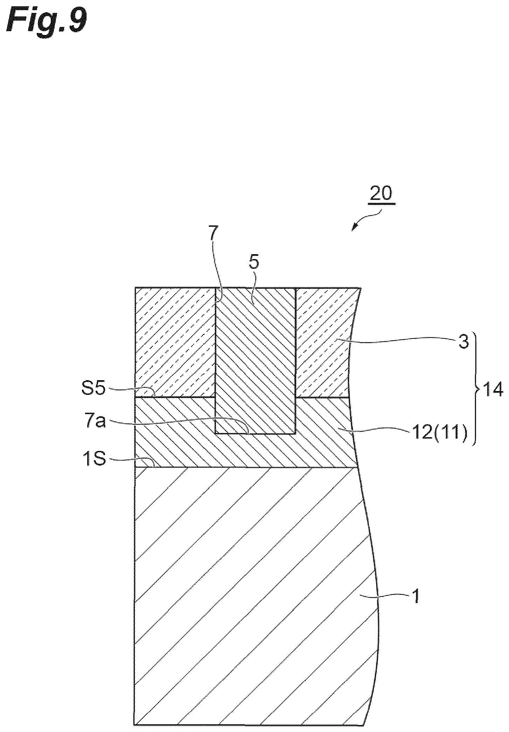

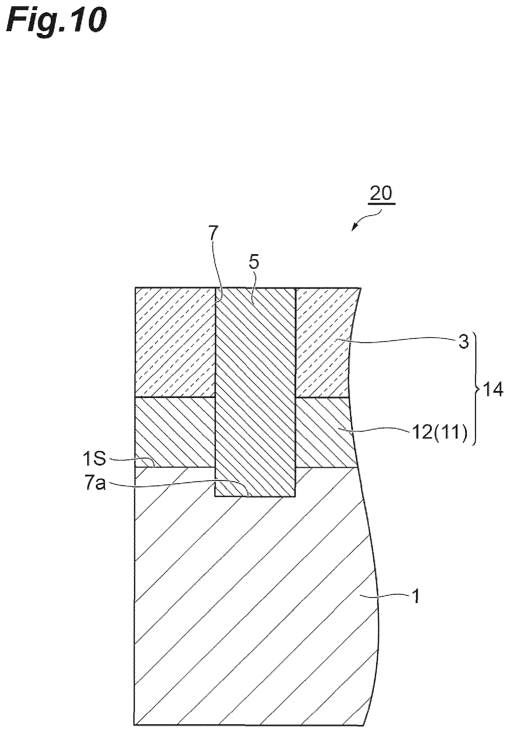

In the above-described embodiment, although the intermediate layer 11 includes the second resin layer 12 and the base layer 13, the base layer 13 may not necessarily be provided in a case where the conductive part 5 is formed by a method other than electroless plating. In a case where the base layer 13 is not provided, the second resin layer 12 is provided between the base material 1 and the first resin layer 3, so that adhesion between the base material 1 and the first resin layer 3 can be improved. In a case where the intermediate layer 11 does not have the base layer 13, the intermediate layer 11 may be formed of the second resin layer 12. The bottom portion 7a of the trench 7 is only sufficient to be positioned closer to the base material 1 than the interface between the first resin layer 3 and the second resin layer 12, and for example, may coincide with the interface between the second resin layer 12 and the base material 1, may be positioned between the interface S5 between the first resin layer 3 and the second resin layer 12, and the interface 1S between the second resin layer 12 and the base material 1 as illustrated in FIG. 9, or may be positioned in the base material 1 as illustrated in FIG. 10.

Furthermore, in the above-described embodiment, the conductive film 20 includes the intermediate layer 11 and the first resin layer 3 on the main surface 1S of the base material 1, but may further include an intermediate layer 11 and a first resin layer 3 on the main surface S3 opposite to the main surface 1S of the base material 1, in this order.

In the above-described embodiment, the trench 7 and the conductive part 5 are provided over a partial region of the main surface 1S of the base material 1, but may be provided over the entire region of the main surface 1S of the base material 1.

Furthermore, in the above-described embodiment, the intermediate layer 11 is provided to cover the entire main surface 1S of the base material 1, but the intermediate layer 11 may be provided to cover a partial region of the main surface 1S of the base material 1. In this case, the remaining region of the main surface 1S of the base material 1 is not covered with the intermediate layer 11 but directly covered with the first resin layer 3. In this case, the thickness of the intermediate layer 11 is preferably 10% or less of the thickness of the first resin layer 3 from the viewpoint of reducing the step between a film on a partial region of the main surface 1S of the base material 1 and a film on the remaining region of the main surface 1S of the base material 1.

### Reference Signs List

- 1: Base material
- 1S: Main surface
- 3: First resin layer
- 5: Conductive part
- 7: Trench
- 7A: Pattern
- 11: Intermediate layer
- 12: Second resin layer
- 13: Base layer
- 14: Structure
- 20: Conductive film
- 100: Display device
- X: Intersecting portion
- S1: First interface (interface between first resin layer and intermediate layer)

## Claims

1. A conductive film comprising:
a film-shaped base material; and a structure provided on one or each of two main surfaces of the base material, wherein
the structure includes
a first resin layer provided at a position farthest from the main surface of the base material,
an intermediate layer provided between the first resin layer and the base material,
a pattern including a linear trench formed along the main surface of the base material,
a conductive part filled in the pattern, and
a bottom portion of the trench is positioned closer to the base material than an interface between the first resin layer and the intermediate layer.

2. The conductive film according to claim 1, wherein the intermediate layer includes a second resin layer, and
a Young's modulus of the second resin layer is less than a Young's modulus of the first resin layer.

3. The conductive film according to claim 2, wherein the intermediate layer further includes a base layer between the second resin layer and the first resin layer, and a Young's modulus of the base layer is less than a Young's modulus of the first resin layer.

4. The conductive film according to claim 3, wherein a bottom portion of the trench is positioned between the base layer and the base material.

5. The conductive film according to claim 1, wherein the pattern includes a plurality of linear trenches intersecting each other.

6. The conductive film according to claim 5, wherein the pattern is a mesh-like pattern.

7. A display device comprising the conductive film according to any one of claims 1 to 6.
